# EUROPÄISCHE PATENTANMELDUNG

(11) **EP 3 208 840 A1**
(43) Veröffentlichungstag der Anmeldung: **23.08.2017**
(21) Anmeldenummer: 16156492.7
(22) Anmeldetag: 19.02.2016
(51) Int. Cl.: H01L 23/367, H01L 23/373, H01L 21/48, H05K 7/20

(54) **WÄRMESPREIZPLATTE MIT MINDESTENS EINER KÜHLFINNE, VERFAHREN ZUR HERSTELLUNG EINER WÄRMESPREIZPLATTE MIT MINDESTENS EINER KÜHLFINNE, ELEKTRONIKMODUL**

(71) Anmelder: Heraeus Deutschland GmbH & Co. KG, 63450 Hanau (DE)
(72) Erfinder: EISELE, Ronald, 24229 Surendorf (DE)
(74) Vertreter: Kilchert, Jochen

(57) **Zusammenfassung**

Die Erfindung betrifft eine Wärmespreizplatte (10) mit mindestens einer Kühlfinne (50), wobei die Wärmespreizplatte (10) mindestens eine erste Schicht (20) und mindestens eine zweite Schicht (30) aufweist, wobei mindestens ein aus einer Grundfläche (31) der zweiten Schicht (30) herausgebogener Flächenabschnitt (50) eine Kühlfinne bildet.

## Beschreibung

Die Erfindung betrifft eine Wärmespreizplatte mit mindestens einer Kühlfinne. Des Weiteren betrifft die Erfindung ein Verfahren zur Herstellung einer Wärmespreizplatte mit mindestens einer ersten Schicht und mindestens einer zweiten Schicht und mindestens einer Kühlfinne. Außerdem betrifft die Erfindung ein Elektronikmodul mit mindestens einem Elektronikbauteil und mindestens einer Wärmespreizplatte.

Leistungselektronische Halbleiter und ihre Schaltungsträger müssen zur Entwärmung der Verlustleistung thermische Pfade zur Umgebung eröffnen. Die genannten Baugruppen werden typischerweise mit ihren Schaltungsträgern auf Wärmeleitplatten aus Kupfer angeordnet. Um die leistungselektronischen Halbleiter und ihre Schaltungsträger zu kühlen, ist es bekannt, Kühlungen mit Hilfe von Flüssigkeiten und/oder Gasen durchzuführen. Hierzu sind an den Wärmeleitplatten bzw. an Wärmespreizplatten Kühlfinnen angeformt. Derartige Kühlfinnen stehen typischerweise über die Grundfläche der Wärmeleitplatte bzw. Wärmespreizplatte über. Der Grad der erreichbaren Entwärmung durch die Kühlfinnen hängt im Wesentlichen von der Flächenvergrößerung ab, die diese Kühlfinnen gegenüber der ebenen Grundfläche erreichen.

Die Flächenvergrößerung bzw. die Herstellung der Kühlfinnen erfolgt beispielsweise durch Fräsen aus einer Massivplatte oder mit Hilfe verschiedenster Gusstechniken. Es ist auch bekannt, die Form der Kühlfinnen durch warmes oder kaltes Fließpressen oder additive Techniken wie Schweißen oder Löten herzustellen.

Insgesamt ist die Herstellung von Wärmespreizplatten durch die formgebenden Fertigungsprozesse technologisch aufwendig und teuer. Bei der Herstellung von Kühlfinnen durch ein Fräsen selbiger aus einer Massivplatte wird äußerst viel Material durch diese subtraktive Fertigung verbraucht. Kupferguss, der insbesondere mit Sandformen hergestellt wird, erzeugt zwar einen geringeren Materialverbrauch, allerdings wird mit dieser Herstellungsmethode aufgrund hoher Formtoleranzen Ausschuss erzeugt. Aufgrund der groben Materialoberfläche ist außerdem oftmals ein abschließender Oberflächenglättungsschritt notwendig.

Auch die Fertigung von Wärmespreizplatten bzw. Wärmeleitplatten mit Kühlfinnen auf Grundlage eines pulverbasierten Metallspritzguss-Verfahrens ist bekannt.
Ein derartiges Verfahren ist jedoch aufgrund der großen Anzahl von Prozessschritten aufwendig und teuer.

Ausgehend von diesem Stand der Technik ist es Aufgabe der vorliegenden Erfindung, eine weiterentwickelte Wärmespreizplatte mit mindestens einer Kühlfinne anzugeben, die äußerst einfach und kostengünstig herzustellen ist und hinsichtlich einer Flächenvergrößerung vorteilhaft ausgebildet ist.

Des Weiteren ist es Aufgabe der vorliegenden Erfindung, ein Verfahren zur Herstellung einer Wärmespreizplatte anzugeben, wobei das Verfahren einfach und kostengünstig durchzuführen ist und eine erhebliche Flächenvergrößerung ohne zusätzlichen Materialaufwand erzielt werden kann.

Des Weiteren ist es eine Aufgabe der vorliegenden Erfindung, ein Elektronikmodul mit mindestens einem Elektronikbauteil und einer erfindungsgemäßen Wärmespreizplatte oder einer erfindungsgemäß hergestellten Wärmespreizplatte anzugeben.

Erfindungsgemäß wird die Aufgabe mit Blick auf die Wärmespreizplatte mit mindestens einer Kühlfinne durch den Gegenstand des Anspruches 1, mit Blick auf das Verfahren zur Herstellung einer Wärmespreizplatte mit mindestens einer ersten Schicht und mindestens einer zweiten Schicht und mindestens einer Kühlfinne durch den Gegenstand des Anspruches 8 und mit Blick auf das Elektronikmodul mit mindestens einem Elektronikbauteil und mindestens einer Wärmespreizplatte durch den Gegenstand des Anspruches 14 gelöst.

Die Erfindung beruht auf dem Gedanken, eine Wärmespreizplatte mit mindestens einer Kühlfinne anzugeben, wobei die erfindungsgemäße Wärmespreizplatte mindestens eine erste Schicht und mindestens eine zweite Schicht aufweist, wobei mindestens ein aus einer Grundfläche der zweiten Schicht herausgebogener Flächenabschnitt eine Kühlfinne bildet.

Die Wärmespreizplatte kann auch als Wärmeleitplatte bzw. Wärmesenkenplatte bezeichnet werden.

Erfindungsgemäß weist die Wärmespreizplatte mindestens zwei Schichten auf, wobei die mindestens zweite Schicht mindestens einen aus der Grundfläche herausgebogenen Flächenabschnitt aufweist, wobei dieser Flächenabschnitt eine Kühlfinne bildet.

Als herausgebogener Flächenabschnitt ist jeder Flächenabschnitt zu verstehen, der hinsichtlich der Grundfläche eine andere Orientierung aufweist und zumindest abschnittsweise einen Biegungsabschnitt aufweist. Mit anderen Worten kann der herausgebogene Flächenabschnitt auch herausgeklappt und/oder herausgepresst und/oder herausgedrückt sein, wobei auch diese Flächenabschnitte zumindest abschnittsweise einen Biegungsabschnitt aufweisen.

Die zweite Schicht ist mit dem mindestens einen herausgebogenen Flächenabschnitt monolithisch, d.h. einteilig, ausgebildet. Der herausgebogene Flächenabschnitt ist mit der Grundfläche verbunden. Dieser Verbindungsabschnitt kann der Biegungsabschnitt des Flächenabschnitts sein. An den Biegungsabschnitt kann sich ein flächenvergrößernder Abschnitt anschließen. Mit anderen Worten ist der flächenvergrößernde Abschnitt der Kühlfinne mittels eines Biegungsabschnittes mit der Grundfläche verbunden.

Die erste Schicht und/oder die mindestens zweite Schicht ist bzw. sind vorzugsweise aus wärmeleitfähigem Material gebildet. Vorzugsweise sind sowohl die erste Schicht als auch die mindestens zweite Schicht aus wärmeleitfähigem Material gebildet. In einer bevorzugten Ausführungsform der Erfindung ist bzw. sind die erste Schicht und/oder die mindestens zweite Schicht aus Kupfer und/oder einer Kupferlegierung und/oder Aluminium und/oder einer Aluminiumlegierung und/oder Aluminiumsiliziumcarbid (AlSiC) gebildet.

Zwischen der ersten Schicht und der zweiten Schicht kann eine Verbindungsschicht, insbesondere eine Sinterschicht oder Klebeschicht oder Lotschicht, ausgebildet sein.

Vorzugsweise wird das Verbindungsmaterial als Sintermaterial bzw. Bestandteil des Sintermaterials zwischen die mindestens erste Schicht und die mindestens zweite Schicht eingebracht. Eine zu einer leitfähigen Schicht sinterfähige Zusammensetzung kann demnach zur Herstellung einer Sinterverbindung zwischen den zu verbindenden Schichten verwendet werden. Die noch sinterfähige Zusammensetzung kann die Anwendungsform einer Tinte, einer Paste oder einer Sinter-Vorform in Form eines schichtförmigen Presslings besitzen. Sinter-Vorformen bzw. sogenannte Sinter-Preforms entstehen durch Applikation und Trocknung von Metallpasten bzw. Metall-Sinterpasten. Derartige Sinter-Vorformen sind noch sinterfähig.

Alternativ ist es möglich, dass das Verbindungsmaterial als Folie, insbesondere als Metallfolie, ausgebildet ist und diese Folie, insbesondere Metallfolie, zwischen der ersten Schicht und der zweiten Schicht angeordnet wird.

Es ist möglich, dass die Sinterpaste durch Drucken, insbesondere Sieb- oder Schablonendrucken, auf die erste Schicht und/oder die zweite Schicht aufgebracht wird. Optional kann die Sinterpaste bzw. Metall-Sinterpaste vor dem Durchführen des eigentlichen Sinterverfahrens getrocknet werden. Ohne den flüssigen Zustand zu durchlaufen, verbinden sich die Metallteilchen der Sinterpaste während des Sinterns durch Diffusion unter Ausbildung einer festen, elektrischen Strom- und Wärme-leitenden metallischen Verbindung bzw. Metallverbindung zwischen der mindestens ersten und mindestens zweiten Schicht. Besonders bevorzugt wird beim Verbinden der mindestens ersten und mindestens zweiten Schicht eine Sinterpaste verwendet, die Silber und/oder eine Silberlegierung und/oder Silbercarbonat und/oder Silberoxid umfasst.

Außerdem ist es möglich, dass eine Sinterpaste verwendet wird, die Gold (Au) und/oder eine Goldlegierung und/oder Kupfer (Cu) und/oder eine Kupferlegierung aufweist.

In einer weiteren Ausführungsform der Erfindung kann zwischen der ersten Schicht und der zweiten Schicht eine dritte Schicht aus einem dehnungsarmen Material ausgebildet sein. Bei dem dehnungsarmen Material kann es sich um eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), handeln. Als besonders bevorzugtes Material hinsichtlich des dehnungsarmen Materials der dritten Schicht hat sich Molybdän (Mo) bzw. eine Molybdänlegierung erwiesen. Die dritte Schicht kann demnach aus Molybdän oder einer Molybdänlegierung bestehen oder Molybdän oder eine Molybdänlegierung aufweisen.

Die dritte Schicht aus einem dehnungsarmen Material bewirkt eine Dehnungsreduzierung bei steigender Temperatur und vermindert auf diese Weise den Dehnungsunterschied zu Materialien einer elektronischen Baugruppe, die mit der Wärmespreizplatte verbunden ist oder verbunden werden kann. Aufgrund der dritten Schicht aus einem dehnungsarmen Material kann vermieden werden, dass in einer Fügezone zwischen einer elektronischen Baugruppe und der Wärmespreizplatte stressbedingte Risse entstehen und als Folge der Risse der Wärmestrom signifikant verhindert wird. Dies ist besonders vorteilhaft, wenn die zu verbindende elektronische Baugruppe oder die verbundene elektronische Baugruppe einen Schaltungsträger aufweist, der eine geringere thermische Dehnung als die erste Schicht und/oder die zweite Schicht der Wärmespreizplatte aufweist.

Die mindestens eine Kühlfinne kann stiftartig oder rechteckig oder halbkreisförmig oder quadratisch ausgebildet sein. Hierbei handelt es sich nicht um eine abschließende Aufzählung geometrischer Figuren. Auch andere Formen der mindestens einen Kühlfinne sind möglich. Beispielsweise kann die mindestens eine Kühlfinne vieleckig, insbesondere dreieckig oder fünfeckig, ausgebildet sein.

Sofern die Wärmespreizplatte mehrere Kühlfinnen aufweist, ist es möglich, dass die Kühlfinnen unterschiedliche Formen aufweisen.

Ein/der herausgebogene Flächenabschnitt kann in einem Winkel von 10° - 90° zur Grundfläche der zweiten Schicht angeordnet sein. Insbesondere der flächenvergrößerende Abschnitt des herausgebogenen Flächenabschnitts kann in einem Winkel von 10° - 90° zur Grundfläche ausgebildet sein. Vorzugsweise ist ein/der herausgebogene Flächenabschnitt senkrecht zur Grundfläche der zweiten Schicht ausgebildet.

Sofern die Wärmespreizplatte mehrere Kühlfinnen aufweist, weisen die Kühlfinnen, insbesondere die herausgebogenen Flächenabschnitte, vorzugsweise den gleichen Winkel auf, in dem diese zur Grundfläche der zweiten Schicht angeordnet sind.

Sofern mehrere Kühlfinnen, die als aus einer Grundfläche herausgebogene Flächenabschnitte gebildet sind, ausgebildet sind, ist es vorteilhaft, wenn diese Kühlfinnen im gleichen Abstand zueinander angeordnet sind.

Die Oberfläche der Wärmespreizplatte kann zumindest abschnittsweise eine korrosionshemmende Beschichtung, insbesondere eine galvanische Nickel-Beschichtung, aufweisen. Als Oberfläche der Wärmespreizplatte ist sowohl die Oberfläche der ersten Schicht, als auch die Oberfläche der zweiten Schicht zu verstehen. Die Oberfläche der Wärmespreizplatte schließt auch die Kühlfinnen mit ein. Auch die zur zweiten Schicht weisende zweite Seite der ersten Schicht kann zumindest abschnittsweise die Oberfläche der Wärmespreizplatte bilden. Diese zweite Seite der ersten Schicht ist in den Abschnitten freigelegt, in denen aus der Grundfläche der zweiten Schicht herausgebogene Flächenabschnitte ausgebildet sind.

Vorzugsweise ist die vollständige Oberfläche der Wärmespreizplatte mit einer korrosionshemmenden Beschichtung versehen. Bei der korrosionshemmenden Beschichtung kann es sich um eine zweifache, galvanische Nickel-Beschichtung handeln. Eine korrosionshemmende Beschichtung der Oberfläche der Wärmespreizplatte ist vor allen Dingen dann vorteilhaft, wenn die Wärmespreizplatte im Zusammenhang mit einer Wasserkühlung bzw. Flüssigkühlung eingesetzt wird.

Alternativ ist es möglich, dass lediglich die zweite Schicht oder die zweite Seite der zweiten Schicht und die Kühlfinne(n) eine Nickel-Beschichtung aufweist bzw. aufweisen. Zusätzlich können die frei liegenden Abschnitte der zweiten Seite der ersten Schicht eine Beschichtung aufweisen. Besonders diese Abschnitte der Wärmespreizplatte sind im Verwendungszustand Wasser bzw. einer Flüssigkeit ausgesetzt.

Mit Hilfe der erfindungsgemäßen Wärmespreizplatte wird eine Wärmespreizplatte mit mindestens einer Kühlfinne zur Verfügung gestellt, die hinsichtlich der Flächenvergrößerung vorteilhaft ausgebildet ist, wobei die Flächenvergrößerung ohne zusätzlichen Materialaufwand hergestellt ist. Der Anteil des thermischen Widerstandes sinkt proportional mit der Flächenvergrößerung. Vorzugsweise weist die Wärmespreizplatte mehrere Kühlfinnen auf.

Die Flächenvergrößerung bzw. der Flächenzuwachs hinsichtlich einer Kühlfinne, also hinsichtlich eines herausgebogenen Flächenabschnittes, setzt sich aus vier Flächenkomponenten zusammen. Die erste Flächenkomponente ist die Rückseite des herausgebogenen Flächenabschnitts. Bei der Rückseite handelt es sich um die erste Seite der zweiten Schicht, die ursprünglich zur ersten Schicht wies. Bei der zweiten Flächenkomponente handelt es sich um die Berandungsfläche des herausgebogenen Flächenabschnitts. Die Berandungsfläche entspricht der Dicke der zweiten Schicht. Die dritte Flächenkomponente ist die freigelegte Fläche der ersten Schicht. Bei der freigelegten Fläche handelt es sich um eine Fläche der zweiten Seite der ersten Schicht. Die zweite Seite der ersten Schicht weist ursprünglich zur zweiten Schicht. Bei der vierten Flächenkomponente handelt es sich nochmals um die Dicke der zweiten Schicht, wobei diese Berandungsfläche nicht Teil des herausgebogenen Flächenabschnitts sondern Teil des in der Grundfläche verbleibenden Abschnitts der zweiten Schicht ist.

Die Erfindung beruht in einem weiteren nebengeordneten Aspekt auf dem Gedanken, ein Verfahren zur Herstellung einer Wärmespreizplatte anzugeben, wobei die Wärmespreizplatte eine erste Schicht und mindestens eine zweite Schicht sowie mindestens eine Kühlfinne aufweist. Bei der Wärmespreizplatte handelt es sich vorzugsweise um eine vorerwähnte erfindungsgemäße Wärmespreizplatte.

Das erfindungsgemäße Verfahren beruht darauf, dass in eine Grundfläche der zweiten Schicht mindestens eine Schwächungskontur und/oder eine Ausnehmung eingebracht wird, die zumindest abschnittsweise einen Flächenabschnitt derart begrenzt, dass der Flächenabschnitt mit mindestens einer Verbindungsstelle mit der Grundfläche verbunden ist, wobei der Flächenabschnitt anschließend aus der Grundfläche herausgebogen wird.

Die mindestens eine Schwächungskontur und/oder die mindestens eine Ausnehmung ist folglich derart in die zweite Schicht, insbesondere in die Grundfläche der zweiten Schicht, einzubringen, dass keine Schwächungskontur und/oder keine Ausnehmung gebildet wird, die ein vollständiges Herauslösen des Flächenabschnitts aus der zweiten Schicht ermöglicht. Die Schwächungskontur und/oder die Ausnehmung weist eine derartige Form auf, dass mindestens eine Verbindungsstelle des Flächenabschnitts mit der Grundfläche verbunden ist. Die Schwächungskontur und/oder die Ausnehmung ist mit anderen Worten derart auszubilden, dass kein vollständiges Abtrennen des Flächenabschnitts aus der Grundfläche der zweiten Schicht ermöglicht wird.

Bei der Verbindungsstelle mit der Grundfläche handelt es sich vorzugsweise um den späteren Biegungsabschnitt des Flächenabschnitts. Wie vorerwähnt, kann der herausgebogene Flächenabschnitt einen Biegungsabschnitt sowie einen flächenvergrößerten Abschnitt aufweisen.

Nachdem mindestens eine Schwächungskontur und/oder mindestens eine Ausnehmung in die Grundfläche der zweiten Schicht eingebracht wurde bzw. wurden, wird der Flächenabschnitt anschließend aus der Grundfläche herausgebogen.

Als Herausbiegen ist jedes mechanische Vorgehen zu verstehen, das einen Flächenabschnitt mit einem Biegungsabschnitt bildet. Das Herausbiegen kann demnach auch ein Herauspressen oder ein Herausziehen oder ein Herausklappen oder Herausdrücken sein. Diese mechanischen Möglichkeiten zum Bilden eines herausgebogenen Flächenabschnittes bewirken, dass die Verbindungsstelle an der Grundfläche einen Biegungsabschnitt des Flächenabschnitts bildet.

Die Schwächungskontur und/oder die Ausnehmung kann mittels Schneiden, insbesondere Laserschneiden oder Wasserstrahlschneiden, und/oder mittels Fräsen und/oder mittels Stanzen in die Grundfläche der zweiten Schicht eingebracht werden.

Mit dem Einbringen der Schwächungskontur und/oder der Ausnehmung in die Grundfläche der zweiten Schicht wird das Muster bzw. die Geometrie des herauszubiegenden Flächenabschnitts bestimmt. Das Herausbiegen des Flächenabschnitts, der aufgrund des Ausbildens einer Schwächungskontur und/oder einer Ausnehmung zumindest teilweise von der Grundfläche der zweiten Schicht abgetrennt ist, kann mittels eines Oberstempels, insbesondere mittels eines Oberstempels und eines komplementär zum Oberstempel ausgebildeten Gegenstempels, erfolgen.

Das Herausbiegen des Flächenabschnitts mittels eines Oberstempels erfolgt beispielsweise dadurch, dass ein Oberstempel mit beispielsweise einzelnen Ausdrücknasen gegen die zweite Schicht drückt. Die Ausdrücknasen sind am Oberstempel vorzugsweise im gleichen Abstand zueinander angeordnet wie die in der zweiten Schicht ausgebildeten Schwächungskonturen und/oder Ausnehmungen, sofern eine Wärmespreizplatte mit mehreren Kühlfinnen hergestellt wird. Die mindestens eine Ausdrücknase drückt dabei auf den mittels der Schwächungskontur und/oder der Ausnehmung begrenzten Flächenabschnitt.

Ein zum Oberstempel komplementär ausgebildeter Gegenstempel weist vorzugsweise mindestens eine Ausnehmung, vorzugsweise mehrere Ausnehmungen auf, in die die Ausdrücknase(n) des Oberstempels eintauchen kann bzw. eintauchen können. Mit Hilfe der Wandung des Unterstempels kann der zu erzielende Winkel, in dem der Flächenabschnitt von der Grundfläche absteht, definiert werden. Der herausgebogene Flächenabschnitt kann in einem Winkel von 10° - 90° zur Grundfläche der zweiten Schicht angeordnet sein. Die Wandung des Gegenstempels kann demnach abschnittsweise einen Winkel einschließen, der 90° - 170° beträgt.

In einer Ausführungsform der Erfindung kann das Einarbeiten einer Schwächungskontur und/oder einer Ausnehmung sowie das Herausbiegen des Flächenabschnitts durch ein Folgeverbundstanzen erfolgen.

Die zweite Schicht kann mit der ersten Schicht, insbesondere durch Löten oder Diffusionsglühen oder Sintern oder eutektisches Verbinden oder Niedertemperatursintern oder Diffusionslöten oder Kleben, verbunden werden. Es ist möglich, dass die zweite Schicht vor dem Einbringen der Schwächungskontur und/oder der Ausnehmung mit der ersten Schicht verbunden wird. Des Weiteren ist es möglich, dass das Verbinden der ersten Schicht mit der zweiten Schicht vor dem Herausbiegen des Flächenabschnitts erfolgt. Zum Herausbiegen des Flächenabschnitts ist es bei Vorliegen einer mit der ersten Schicht verbundenen zweiten Schicht notwendig, dass der Flächenabschnitt, insbesondere mittels einer Greifvorrichtung, aus der Grundfläche der zweiten Schicht herausgezogen wird. Auch bei einem Herausziehen bildet sich an der Verbindungsstelle des Flächenabschnitts mit der Grundfläche ein Biegungsabschnitt aus.

Es ist möglich, dass zwischen der ersten Schicht und der zweiten Schicht eine dritte Schicht aus einem dehnungsarmen Material ausgebildet wird. Bei dem dehnungsarmen Material kann es sich um eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), handeln. Besonders bevorzugt ist die dritte Schicht aus Molybdän oder einer Molybdänlegierung gebildet.

Sofern eine dritte Schicht zwischen der ersten Schicht und der zweiten Schicht ausgebildet ist, ist es vorteilhaft, die erste Schicht, die zweite Schicht und die dritte Schicht bei einer Verbindungstemperatur von 150 °C - 300 °C, insbesondere durch ein Niedertemperatursinterverfahren, miteinander zu verbinden.

Es ist in einer weiteren Ausführungsform des erfindungsgemäßen Verfahrens möglich, dass die zweite Schicht nach dem Herausbiegen des mindestens einen Flächenabschnitts auf dem Gegenstempel bzw. Unterstempel liegen bleibt. Auf die zweite Schicht werden nacheinander die zu verbindenden Schichten der herzustellenden Wärmespreizplatte aufgelegt. Mit Hilfe eines weiteren Oberstempels, der keine Ausdrücknasen umfasst, kann ein Druck auf alle zu verbindenden Schichten aufgebracht werden. Es ist möglich, dass die Schichten der Wärmespreizplatte mittels Verbindungsschichten, insbesondere mittels Sinterpaste durch das Verfahren des Drucksinterns, stofflich miteinander verbunden werden. Hierzu drückt der Oberstempel auf den Gegenstempel und somit auf die dazwischen befindlichen Schichten der Wärmespreizplatte.

Die Erfindung beruht des Weiteren auf dem Gedanken, ein Elektronikmodul mit mindestens einem Elektronikbauteil und mindestens einer Wärmespreizplatte anzugeben, wobei es sich bei der Wärmespreizplatte um eine vorerwähnte erfindungsgemäße Wärmespreizplatte oder um eine erfindungsgemäß hergestellte Wärmespreizplatte handelt.

Das Elektronikmodul umfasst mindestens ein Elektronikbauteil, das mittelbar oder unmittelbar mit einer ersten Seite der ersten Schicht, die von der zweiten Schicht abgewandt ausgebildet ist, verbunden ist. Die erste Seite der ersten Schicht kann auch als Oberfläche der ersten Schicht bezeichnet werden. Insbesondere auf die Oberfläche der ersten Schicht bzw. auf die erste Seite der ersten Schicht wirkt somit die von dem Elektronikbauteil erzeugte Wärme. Bei einer mittelbaren Verbindung des mindestens einen Elektronikbauteils mit der Oberfläche der ersten Schicht ist es möglich, dass zwischen dem Elektronikbauteil und der Wärmespreizplatte eine Kontaktierungsschicht, insbesondere eine Klebeschicht oder Lotschicht oder Sinterpastenschicht, ausgebildet ist.

Die zweite Schicht der Wärmespreizplatte ist vorzugsweise als ein, einem Kühlmedium, insbesondere Luft und/oder Wasser und/oder Glykol und/oder Öl, ausgesetztes Bauteil ausgebildet.

Die mindestens eine Kühlfinne der Wärmespreizplatte kann in einem Winkel von 10° - 90° zur Strömungsrichtung des Kühlmediums ausgebildet sein. Insbesondere ist es möglich, dass die Kühlfinne parallel oder senkrecht zur Strömungsrichtung des Kühlmediums ausgerichtet ist. In Abhängigkeit des Anwendungsfalls kann die mindestens eine Kühlfinne eine bevorzugte Gestalt und/oder Ausrichtung aufweisen. Folgende Ausführungsbeispiele konnten bei Untersuchungen und hydrodynamischen Simulationen ermittelt werden:
➢ Kühlmedium Luft mit geringem Massestrom:
   Die Kühlfinnen weisen vorzugsweise eine große Kühlfläche auf und sind vorzugsweise quadratisch oder rechteckig ausgebildet; die Kühlflächen der Kühlfinnen werden parallel zur Strömungsrichtung des Kühlmediums angeströmt und weisen große Flächenabstände zueinander auf.
➢ Kühlmedium Luft mit großem Massestrom:
   Die Kühlfinnen weisen vorzugsweise kleine Kühlflächen, insbesondere stiftförmige Kühlflächen, auf; die Kühlflächen der Kühlfinnen werden vorzugsweise parallel zur Strömungsrichtung des Kühlmediums angeströmt und weisen geringe Flächenabstände zueinander auf.
➢ Kühlmedium Wasser (optional mit Glykol) mit geringem Massestrom bei geringem Druckverlust:
   Die Kühlfinnen weisen kleine Kühlflächen auf und sind vorzugsweise stiftförmig oder halbkreisförmig ausgebildet; die Kühlflächen der Kühlfinnen werden parallel bis winkelig zur Strömungsrichtung des Kühlmediums angeströmt und weisen zueinander mittlere Flächenabstände auf.
➢ Kühlmedium Wasser (optional mit Glykol) mit großem Massestrom und hohem Druckverlust:
   Die Kühlfinnen weisen mittlere Kühlflächen auf und sind vorzugsweise rechteckförmig oder halbkreisförmig ausgebildet; die Kühlflächen der Kühlfinnen sind stark winkelig oder senkrecht zur Strömungsrichtung des Kühlmediums angeströmt und weisen vorzugsweise kleine Flächenabstände zueinander auf.
➢ Kühlmedium Öl mit geringem Massestrom:
   Die Kühlfinnen weisen vorzugsweise große Kühlflächen auf und sind insbesondere rechteckförmig oder halbkreisförmig ausgebildet; die Kühlflächen der Kühlfinnen werden vorzugsweise parallel zur Strömungsrichtung des Kühlmediums angeströmt und weisen vorzugsweise große Flächenabstände zueinander auf.
➢ Kühlmedium Öl mit großem Massestrom und großem Druckverlust:
   Die Kühlfinnen weisen große Kühlflächen auf und sind vorzugsweise rechteck- oder halbkreisförmig ausgebildet; die Kühlflächen der Kühlfinnen werden vorzugsweise winkelig zur Strömungsrichtung des Kühlmediums angeströmt und weisen vorzugsweise große Flächenabstände zueinander auf.

Als Kühlfläche einer Kühlfinne wird vorzugsweise die größte Flächenkomponente der Kühlfinne bezeichnet. Die Kühlfläche bzw. die Form der Kühlfläche wird aufgrund der Form der eingebrachten Ausnehmung und/oder der Form der eingebrachten Schwächungskontur bestimmt.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1a: die Anordnung einzelner Schichten und Elemente einer Wärmespreizplatte mit Kühlfinne gemäß einem ersten Ausführungsbeispiel;
- Fig. 1b: eine Wärmespreizplatte mit Kühlfinne gemäß Fig. 1a im verbundenen Zustand;
- Fig. 2: eine Wärmespreizplatte mit mehreren Kühlfinnen;
- Fig. 3: eine Wärmespreizplatte mit mehreren Kühlfinnen gemäß einem weiteren Ausführungsbeispiel;
- Fig. 4: ein erfindungsgemäßes Elektronikmodul mit konkaver Ausbildung der Wärmespreizplatte;
- Fig. 5a - 5e: einzelne Verfahrensschritte hinsichtlich des Herausbiegens eines Flächenabschnitts; und
- Fig. 6a - 6c: einzelne Verfahrensschritte hinsichtlich des Verbindens der einzelnen Schichten der Wärmespreizplatte.

Im Folgenden werden für gleiche und gleichwirkende Teile gleiche Bezugsziffern verwendet.

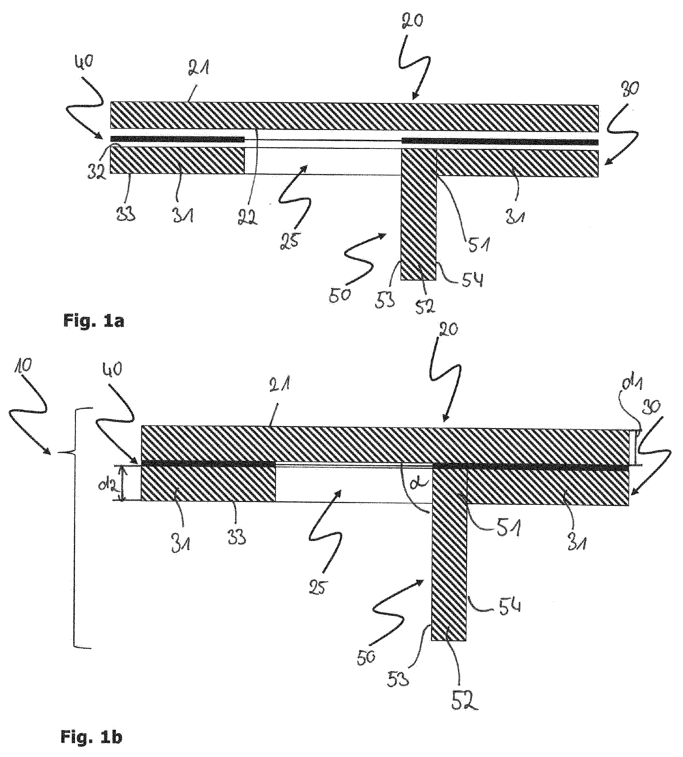

In Fig. 1a sind die einzelnen Schichten und Flächenabschnitte einer herzustellenden Wärmespreizplatte 10 (siehe Fig. 1b) dargestellt. Demnach werden eine erste Schicht 20 und mindestens eine zweite Schicht 30 übereinander angeordnet. Zwischen der ersten Schicht 20 und der zweiten Schicht 30 ist eine Verbindungsschicht 40 ausgebildet. Die zweite Schicht 30 umfasst eine Grundfläche 31, die im Wesentlichen parallel zur ersten Schicht 20 ausgebildet ist. Die erste Schicht 20 weist eine erste Seite 21 sowie eine zweite Seite 22 auf. Die erste Seite 21, die von der zweiten Schicht 30 abgewandt ausgebildet ist, bildet die Oberfläche der herzustellenden Wärmespreizplatte 10. Die zweite Seite 22 der ersten Schicht 20 ist der zweiten Schicht 30 zugewandt. Auch die zweite Schicht 30 weist eine erste Seite 32 auf, die der ersten Schicht 20 zugeordnet ist. Die zweite Seite 33 der zweiten Schicht 30 ist hingegen von der ersten Schicht 20 abgewandt ausgebildet.

Die erste Schicht 20 und die zweite Schicht 30 sind vorzugsweise aus wärmeleitenden Materialien hergestellt. Dabei kann es sich um Kupfer und/oder eine Kupferlegierung und/oder Aluminium und/oder eine Aluminiumlegierung und/oder um Aluminiumsiliziumkarbid handeln. Die Verbindungsschicht 40, die zwischen der ersten Schicht 20 und der zweiten Schicht 30 ausgebildet ist, ist vorzugsweise eine Sinterschicht. Diese Sinterschicht kann beispielsweise Silberpartikel umfassen.

Aus der Grundfläche 31 der zweiten Schicht 30 ist ein Flächenabschnitt 50 herausgebogen. Dieser herausgebogene Flächenabschnitt 50 bildet die Kühlfinne. Der herausgebogene Flächenabschnitt 50 umfasst einen Biegungsabschnitt 51 und einen flächenvergrößernden Abschnitt 52. Aufgrund des herausgebogenen Flächenabschnittes 50 weist die zweite Schicht 30 einen Ausschnitt 25 auf. Aufgrund des Ausschnitts 25 kann im verbundenen Zustand der Schichten 20 und 30 (siehe Fig. 1b) ein Zugang zur zweiten Seite 22 der ersten Schicht 20 hergestellt werden. Im vorliegenden Fall ist die Verbindungsschicht 40 nicht im Ausschnitt 25 ausgebildet. Eine Sinterpaste, die eine Verbindungsschicht 40 bilden kann, kann beispielsweise mit Hilfe von Schablonen auf die erste Schicht 20 oder auf die zweite Schicht 30 aufgebracht werden, so dass die Verbindungsschicht 40 ebenfalls Ausschnitte aufweisen kann. Alternativ ist es möglich, dass die Verbindungsschicht 40 durchgehend, d.h. ohne Ausschnitte, ausgebildet ist.

Der herausgebogene Flächenabschnitt 50 ist vorliegend in einem Winkel α von 90° zur Grundfläche 31 der zweiten Schicht 30 angeordnet. Der Winkel α wird zwischen der Kühlfläche 53 und der zweiten Seite 22 der ersten Schicht 20 gebildet. Mit anderen Worten wird der Winkel α im Bereich des Ausschnitts 25 gebildet.

Die gesamte Oberfläche der Wärmespreizplatte 10 weist vorzugsweise eine galvanisch aufgetragene Nickel-Beschichtung auf. Die Nickel-Beschichtung ist korrosionshemmend. Sofern die Wärmespreizplatte 10 als Wasserkühler eingesetzt wird, vermeidet die galvanische Nickel-Beschichtung Korrosionsbildung. Als Oberfläche der Wärmespreizplatte 10 ist sowohl die erste Seite 21 der ersten Schicht 20 als auch die zweite Seite 33 der zweiten Schicht 30 zu verstehen. Zur Oberfläche der Wärmespreizplatte 10 zählen auch die Kühlflächen 53 und 54 des herausgebogenen Flächenabschnitts 50. Auch der im Ausschnitt 25 liegende Abschnitt der zweiten Seite 22 der ersten Schicht 20 zählt zur Oberfläche. Dies gilt auch für die sichtbaren Dicken d1 und d2 der ersten Schicht 20 sowie der zweiten Schicht 30.

Alternativ ist es möglich, dass lediglich die zweite Schicht 30 oder die zweite Seite 33 der zweiten Schicht 30 und die Kühlfinne 50 eine Nickel-Beschichtung aufweist bzw. aufweisen. Zusätzlich können die frei liegenden Abschnitte der zweiten Seite 22 der ersten Schicht 20 eine Beschichtung aufweisen. Besonders diese Abschnitte der Wärmespreizplatte sind im Verwendungszustand Wasser bzw. einer Flüssigkeit ausgesetzt.

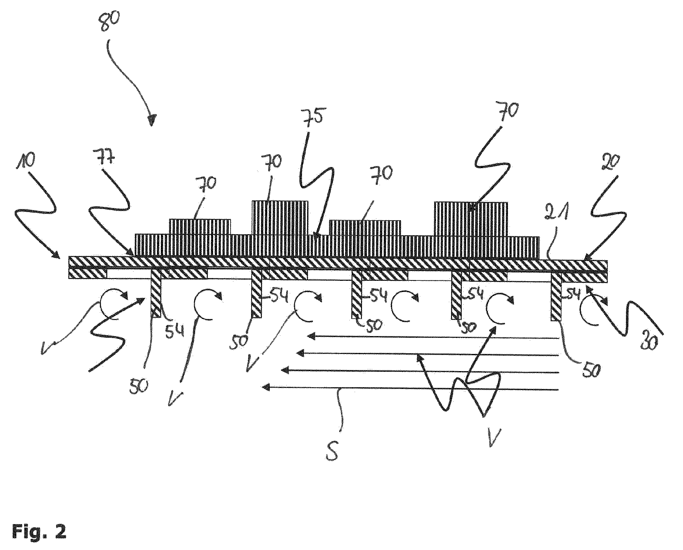

In Fig. 2 ist eine Wärmespreizplatte 10 mit mehreren herausgebogenen Flächenabschnitten 50, die Kühlfinnen bilden, dargestellt. Auf der ersten Seite 21 der ersten Schicht 20 sind mehrere Elektronikbauteile 70 angeordnet. Diese Elektronikbauteile 70 befinden sich auf einer Substratplatte 75. Die Substratplatte 75 ist mit den Elektronikbauteilen 70 beispielsweise mittels einer Lotverbindung 77 auf der ersten Seite 21 der ersten Schicht 20 aufgebracht. Anstelle der Lotverbindung 77 könnte auch eine Klebeverbindung oder eine Sinterverbindung ausgebildet sein. Die Wärmespreizplatte 10 mit den Kühlfinnen 50 sowie die Elektronikbaugruppe, die durch die Substratplatte 75 und die Elektronikbauteile 70 gebildet wird, bilden somit ein Elektronikmodul 80. Die zweite Schicht 30 der Wärmespreizplatte 10 ist als ein einem Kühlmedium ausgesetztes Bauteil ausgebildet. Bei dem Kühlmedium kann es sich beispielsweise um Luft oder eine Flüssigkeit handeln.

Die parallel zueinander ausgebildeten Pfeile deuten die Strömungsrichtung S des Kühlmediums an. Die Kühlfinnen 50 sind senkrecht zur Strömungsrichtung S des Kühlmediums ausgebildet. Die Kühlflächen 54 der Kühlfinnen 50 werden demnach senkrecht von dem Kühlmedium angeströmt. Aufgrund der senkrechten Anströmung der Kühlflächen 54 kommt es zu Verwirbelungen zwischen den Kühlfinnen 50, so dass hier eine besonders gute Kühlleistung vorliegt.

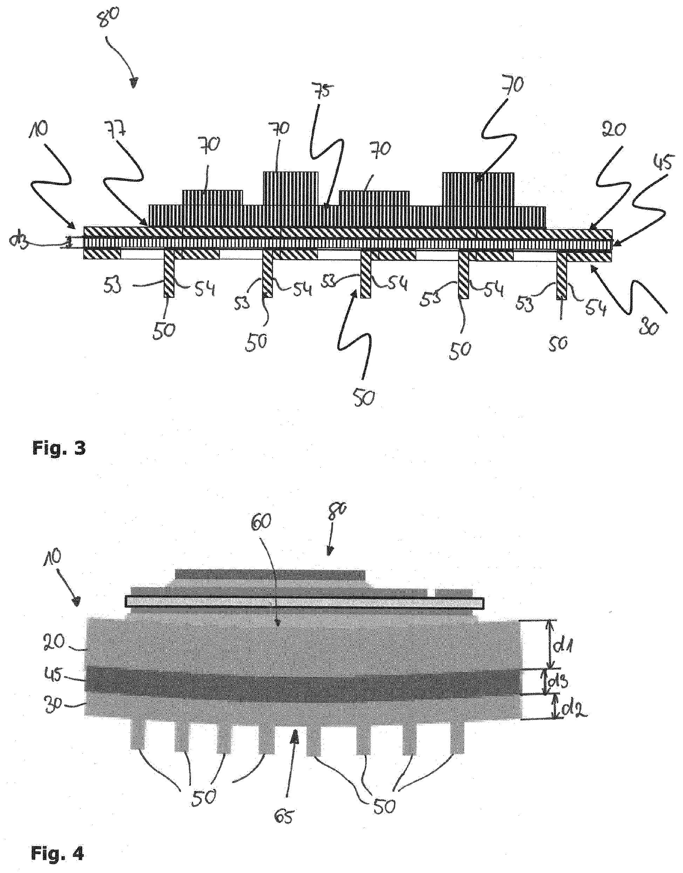

In Fig. 3 wird eine weitere Ausführungsform eines Elektronikmoduls 80 dargestellt. Die dargestellte Wärmespreizplatte 10 weist eine erste Schicht 20, eine zweite Schicht 30 sowie eine dritte Schicht 45 auf. Bei dieser dritten Schicht 45 handelt es sich um eine dehnungsarme Schicht. Bei dem dehnungsarmen Material kann es sich um eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), handeln. Als besonders bevorzugtes Material hinsichtlich des dehnungsarmen Materials der dritten Schicht 45 hat sich Molybdän (Mo) bzw. eine Molybdänlegierung erwiesen. Die dritte Schicht 45 kann demnach aus Molybdän oder einer Molybdänlegierung bestehen oder Molybdän oder eine Molybdänlegierung aufweisen. Diese dehnungsarme dritte Schicht 45 bzw. diese dritte Schicht 45 aus einem dehnungsarmen Material erzeugt eine Dehnungsreduzierung bei steigender Temperatur und vermindert auf diese Art und Weise den Dehnungsunterschied zu den Materialien der Elektronikbauteile 70 bzw. der Substratplatte 75. So wird vermieden, dass in der Fügezone zwischen der Wärmespreizplatte 10 und der Substratplatte 75 stressbedingte Risse entstehen und als Folge der Risse der Wärmestrom signifikant verringert wird. Dies ist typischerweise der Fall bei keramikbasierten Substratplatten, die eine mittlere thermische Dehnung von 4 - 8 ppm/K aufweisen. Die dritte dehnungsarme Schicht 45 ist beispielsweise aus Molybdän gebildet.

In Fig. 4 ist eine weitere Wärmespreizplatte 10 mit Kühlfinnen 50 dargestellt. Der Schichtaufbau dieser Wärmespreizplatte 10 ist asymmetrisch. Das heißt, dass die Dicke d1 der ersten Schicht 20 größer als die Dicke d2 der zweiten Schicht 30 und größer als die Dicke d3 der dritten Schicht 45 ist. Bei der dritten Schicht 45 handelt es sich um eine dehnungsarme Schicht. Aufgrund der asymmetrischen Ausbildung weist die Wärmespreizplatte 10 eine konkave Form auf. Die konkave Form bildet eine Einbuchtung 60 sowie eine ballige Seite 65.

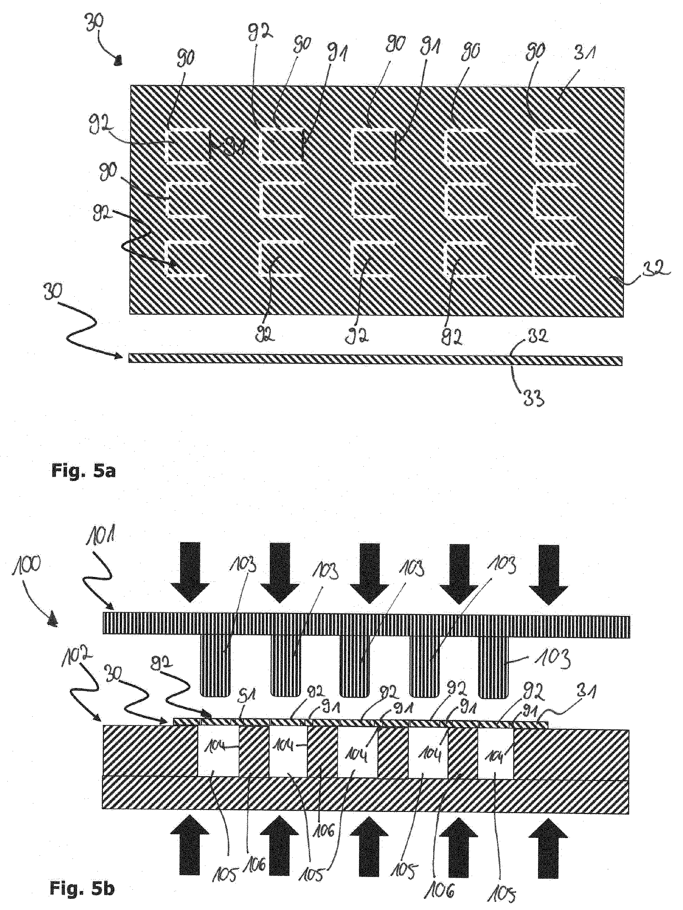

In den Fig. 5a - 5e ist schrittweise dargestellt, wie der herausgebogene Flächenabschnitt 50 der zweiten Schicht 30 hergestellt werden kann. Die Fig. 5a zeigt die zweite Schicht 30 in einer Draufsicht auf die erste Seite 32. Hinsichtlich der Orientierung der ersten Seite 32 und der zweiten Seite 33 sei auf die vorherigen Erläuterungen in Zusammenhang mit den Fig. 1a und 1b verwiesen.

In die zweite Schicht 30 werden mehreren Ausnehmungen 90 eingebracht. Insgesamt werden drei horizontale Reihen und fünf vertikale Spalten mit insgesamt 15 Ausnehmungen 90 gebildet. Die Ausnehmungen 90 sind U-förmig ausgebildet. Ebenfalls ist es denkbar, dass die Ausnehmungen 90 V-förmig oder halbkreisförmig ausgebildet werden. Die Abstände in horizontaler Richtung zwischen den in einer Zeile liegenden Ausnehmungen 90 sind gleich. Auch die Abstände zwischen in horizontaler Richtung nebeneinanderliegender Ausnehmungen 90 sind gleich.

Die Ausnehmungen 90 werden in die zweite Schicht 30 beispielsweise durch Schneiden, insbesondere durch Laserschneiden oder Wasserstrahlschneiden, eingebracht. Es ist auch möglich, dass die Ausnehmungen 90 durch Stanzen oder Fräsen in die zweite Schicht 30 eingebracht werden. Die Ausnehmungen 90 begrenzen die Flächenabschnitte 92, wobei es sich bei diesen Flächenabschnitten 92 um die herauszubiegenden Flächenabschnitte handelt. Im noch nicht herausgebogenen Zustand befinden sich alle Flächenabschnitte 92 in der gleichen Ebene wie die Grundfläche 31 der zweiten Schicht 30. Jeder Flächenabschnitt 92 ist an mindestens einer Verbindungsstelle 91 mit der Grundfläche 31 verbunden. Mit anderen Worten ist die Ausnehmung 90 derart in die Grundfläche 31 einzubringen, dass der Flächenabschnitt 92 nicht aus der Grundfläche 31 vollständig herausgetrennt werden kann. Die Verbindungsstelle 91 bildet den späteren Biegungsabschnitt 51. Mit der Form der Ausnehmung 90 wird die Kontur bzw. die Geometrie des später herausgebogenen Flächenabschnittes 50 bestimmt.

Nachdem die Ausnehmungen 90 in die zweite Schicht 30 eingebracht wurden, werden die Flächenabschnitte 92 aus der Grundfläche 31 herausgedrückt. Hierzu wird die zweite Schicht 30 in eine Stempelvorrichtung 100 eingelegt. Die Stempelvorrichtung 100 umfasst einen Oberstempel 101 und einen Gegenstempel 102. Der Oberstempel 101 weist Ausdrücknasen 103 auf. Vorzugsweise weist der Oberstempel 101 derart viele Ausdrücknasen 103 auf, wie herausgebogene Flächenabschnitte 50 hergestellt werden sollen. Die zweite Schicht 30 wird derart in der Stempelvorrichtung 100 positioniert, dass die Ausdrücknasen 103 auf die Flächenabschnitte 92 drücken können. Vorzugsweise liegen die Verbindungsstellen 91 an den Kanten der Wandungen 104 des Gegenstempels 102 an. Der Gegenstempel 102 weist Ausnehmungen 105 auf, in die die Ausdrücknasen 103 gleiten können.

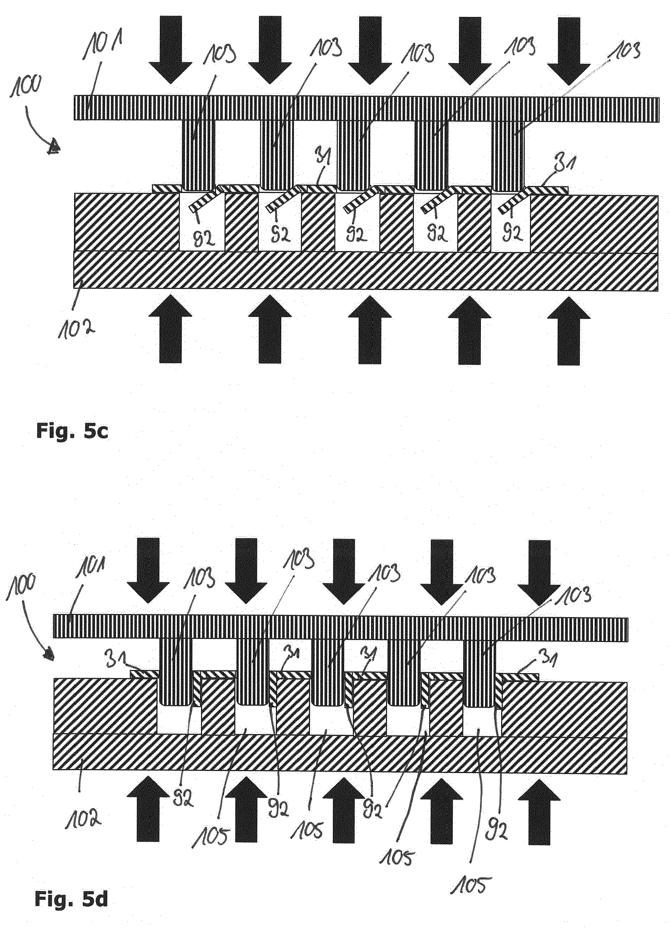

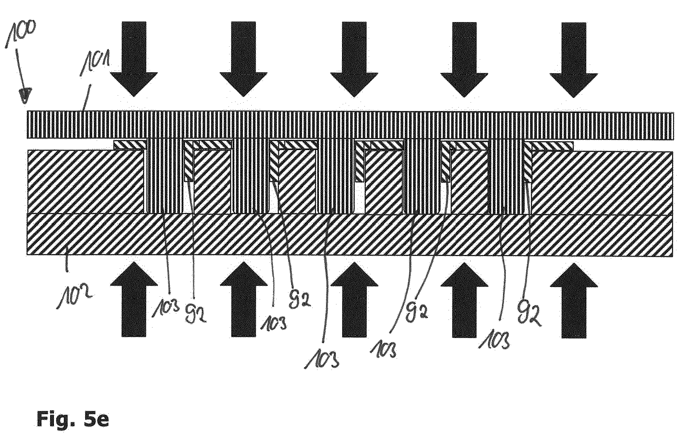

Wie in Fig. 5e dargestellt ist, werden die Flächenabschnitte 92 aufgrund der in Pfeilrichtung herrschenden Drücke des Oberstempels 101 und des Gegenstempels 102 aus der Grundfläche 31 herausgedrückt bzw. herausgebogen. Die Grundfläche 31 bleibt auf den Amboss-artigen Gegenelementen 106 (siehe Fig. 5c) des Gegenstempels 102 liegen.

Wie in Fig. 5d dargestellt ist, sind die Ausnehmungen 105 breiter als die Ausdrücknasen 103, so dass die Flächenabschnitte 92 senkrecht entlang der Wandung 104 nach unten gedrückt werden können.

Wie in Fig. 5e dargestellt wird, wird der Oberstempel 101 derart in den Gegenstempel 102 gedrückt, dass der Flächenabschnitt 92 90° zur Grundfläche 31 gebogen ist. In diesem Zustand liegt ein vollständig herausgebogener Flächenabschnitt 50 vor. Die Form der Wandungen 104 (siehe Fig. 5b) bestimmt den späteren Winkel α. An jeweils einer Kante einer Wandung 104 werden die späteren Biegungsabschnitte 51 gebildet.

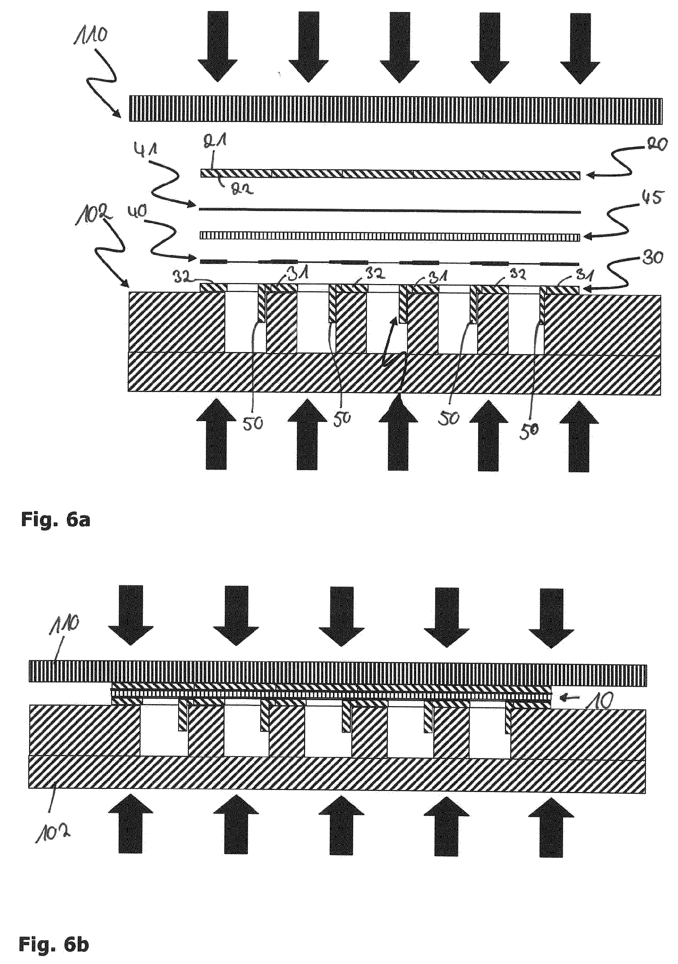

In den Fig. 6a bis 6c wird beispielhaft dargestellt, wie die zweite Schicht 30 mit den anderen Schichten der herzustellenden Wärmespreizplatte 10 verbunden werden kann. Hierzu wird der Oberstempel 101 mit den Ausdrücknasen 103 entfernt. Die zweite Schicht 30 verbleibt mit den herausgebogenen Flächenabschnitten 50 im Gegenstempel (siehe Fig. 6a). Auf die erste Seite 32 der zweiten Schicht 30 kann zunächst eine Verbindungsschicht 40 aufgebracht werden. Bei dieser Verbindungsschicht 40 kann es sich beispielsweise um eine Klebeschicht oder um eine Sinterschicht oder um eine Lotschicht handeln. Vorzugsweise wird die Verbindungsschicht 40 lediglich auf der Grundfläche 31 der ersten Seite 32 aufgetragen. Auf der Verbindungsschicht 40 wird vorzugsweise die dritte Schicht 45 aus einem dehnungsarmen Material aufgebracht. Bei der dritten Schicht 45 kann es sich beispielsweise um eine Molybdänschicht handeln. Auf der dritten Schicht 45 kann wiederum eine Verbindungsschicht 41 aufgebracht werden. Auch hier kann es sich um eine Klebeschicht oder um eine Sinterschicht oder um eine Lotschicht handeln. Anschließend wird die erste Schicht 20 angeordnet. Die zweite Seite 22 der ersten Schicht 20 weist in Richtung der zweiten Schicht 30.

Die Anordnung der einzelnen Schicht 20, 30, 40, 41 und 45 wird, wie in Fig. 6b dargestellt, mit Hilfe eines Oberstempels 110 und eines Gegenstempels 102 verpresst. Beispielsweise kann dies im Rahmen eines Niederdrucktemperatursinterverfahrens erfolgen. Hierbei erfolgt eine Wärmebeaufschlagung bei Temperaturen von 150 °C - 300 °C. Durch das Aufbringen von Drücken, die zwischen 5 MPa und 30 MPa, insbesondere 25 MPa, betragen, bei einer Temperatur von 250 °C für eine Dauer von vorzugsweise 1 bis 10 min, beispielsweise 4 min, wird eine haltbare Sinterverbindung geschaffen.

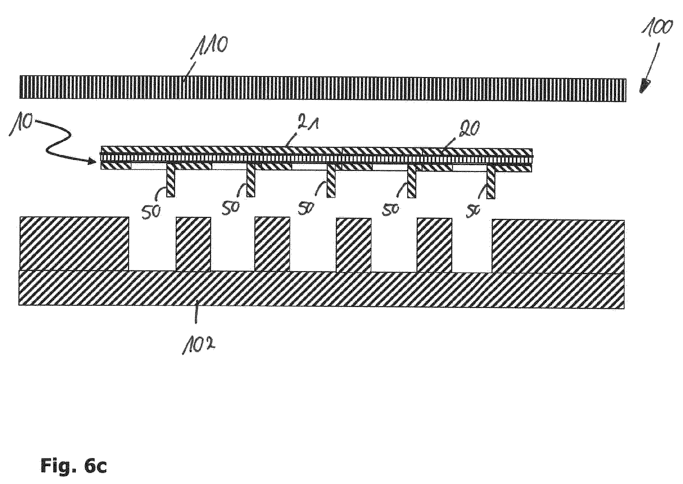

Wie in Fig. 6c dargestellt, erfolgt anschließend das Abnehmen des Oberstempels 110, so dass die Wärmespreizplatte 10 der Stempelvorrichtung 100 entnommen werden kann.

Abschließend kann die Wärmespreizplatte 10 vollständig mit einer korrosionshemmenden Beschichtung versehen werden. Beispielsweise kann auf die vollständige Oberfläche der Wärmespreizplatte 10 eine Nickel-Beschichtung aufgebracht werden.

### Bezugszeichenlistes

- 10: Wärmespreizplatte
- 20: erste Schicht
- 21: erste Seite erste Schicht
- 22: zweite Seite erste Schicht
- 25: Ausschnitt
- 30: zweite Schicht
- 31: Grundfläche
- 32: erste Seite zweite Schicht
- 33: zweite Seite zweite Schicht
- 40: Verbindungsschicht
- 41: Verbindungsschicht
- 45: dritte Schicht
- 50: herausgebogener Flächenabschnitt
- 51: Biegungsabschnitt
- 52: flächenvergrößernder Abschnitt
- 53: Kühlfläche
- 54: Kühlfläche
- 60: Einbuchtung
- 65: ballige Seite
- 70: Elektronikbauteil
- 75: Substratplatte
- 77: Lotschicht
- 80: Elektronikmodul
- 90: Ausnehmung
- 91: Verbindungsstelle
- 92: Flächenabschnitt
- 100: Stempelvorrichtung
- 101: Oberstempel
- 102: Gegenstempel
- 103: Ausdrücknase
- 104: Wandung
- 105: Ausnehmung
- 106: Gegenelement
- 110: Oberstempel
- d1: Dicke erste Schicht
- d2: Dicke zweite Schicht
- d3: Dicke dritte Schicht
- S: Strömungsrichtung Kühlmedium
- V: Verwirbelung
- α: Winkel zwischen Grundfläche und herausgebogenem Flächenabschnitt

## Patentansprüche

1. Wärmespreizplatte (10) mit mindestens einer Kühlfinne (50),
**dadurch gekennzeichnet, dass**
die Wärmespreizplatte (10) mindestens eine erste Schicht (20) und mindestens eine zweite Schicht (30) aufweist, wobei mindestens ein aus einer Grundfläche (31) der zweiten Schicht (30) herausgebogener Flächenabschnitt (50) eine Kühlfinne bildet.

2. Wärmespreizplatte (10) nach Anspruch 1,
**dadurch gekennzeichnet, dass**
die erste Schicht (20) und/oder die zweite Schicht (30) aus Kupfer und/oder einer Kupferlegierung und/oder Aluminium und/oder einer Aluminiumlegierung und/oder Aluminiumsiliziumkarbid (AlSiC) gebildet ist.

3. Wärmespreizplatte (10) nach Anspruch 1 oder 2,
**dadurch gekennzeichnet, dass**
zwischen der ersten Schicht (20) und der zweiten Schicht (30) eine Verbindungsschicht (40, 41), insbesondere eine Sinterschicht oder Klebeschicht oder Lotschicht, ausgebildet ist.

4. Wärmespreizplatte (10) nach einem der vorhergehenden Ansprüche,
**dadurch gekennzeichnet, dass**
zwischen der ersten Schicht (20) und der zweiten Schicht (30) mindestens eine dritte Schicht (45) aus einem dehnungsarmen Material, insbesondere aus einer Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder einer Eisen-Nickel-Kobalt-Legierung (FeNiCo-Legierung), besonders bevorzugt Molybdän (Mo), ausgebildet ist.

5. Wärmespreizplatte (10) nach einem der vorhergehenden Ansprüche,
**dadurch gekennzeichnet, dass**
die mindestens eine Kühlfinne (50) stiftartig oder rechteckig oder halbkreisförmig oder quadratisch ausgebildet ist.

6. Wärmespreizplatte (10) nach einem der vorhergehenden Ansprüche,
**dadurch gekennzeichnet, dass**
ein/der herausgebogene Flächenabschnitt (51) in einem Winkel von 10° - 90° zur Grundfläche (31) der zweiten Schicht (30) angeordnet ist.

7. Wärmespreizplatte (10) nach einem der vorhergehenden Ansprüche,
**gekennzeichnet durch**
eine zumindest abschnittsweise ausgebildete korrosionshemmende Beschichtung, insbesondere eine galvanische Nickel-Beschichtung, der Oberfläche der Wärmespreizplatte (10).

8. Verfahren zur Herstellung einer Wärmespreizplatte (10) mit mindestens einer ersten Schicht (20) und einer zweiten Schicht (30) und mindestens einer Kühlfinne (50), insbesondere zur Herstellung einer Wärmespreizplatte (10) nach einem der Ansprüche 1 bis 7,
**dadurch gekennzeichnet, dass**
in eine Grundfläche (31) der zweiten Schicht (30) mindestens eine Schwächungskontur und/oder eine Ausnehmung (90) eingebracht wird, die zumindest abschnittsweise einen Flächenabschnitt (92) derart begrenzt, dass der Flächenabschnitt (92) mit mindestens einer Verbindungsstelle (91) mit der Grundfläche (31) verbunden ist, wobei der Flächenabschnitt (92) anschließend aus der Grundfläche (31) herausgebogen wird.

9. Verfahren nach Anspruch 8,
**dadurch gekennzeichnet, dass**
die Schwächungskontur und/oder die Ausnehmung (90) mittels Schneiden, insbesondere Laserschneiden oder Wasserstrahlschneiden, und/oder mittels Fräsen und/oder mittels Stanzen in die Grundfläche (31) der zweiten Schicht (30) eingebracht wird.

10. Verfahren nach einem der Ansprüche 8 oder 9,
**dadurch gekennzeichnet, dass**
das Herausbiegen des Flächenabschnitts (92) mittels eines Oberstempels (101), insbesondere mittels eines Oberstempels (101) und eines komplementär ausgebildeten Gegenstempels (102), erfolgt.

11. Verfahren nach einem der Ansprüche 8 bis 10,
**dadurch gekennzeichnet, dass**
die zweite Schicht (30) mit der ersten Schicht (20), insbesondere durch Löten oder Diffusionsglühen oder Sintern oder eutektisches Verbinden oder Niedertemperatursintern oder Diffusionslöten oder Kleben, verbunden wird.

12. Verfahren nach einem der Ansprüche 8 bis 11,
**dadurch gekennzeichnet, dass**
zwischen der ersten Schicht (20) und der zweiten Schicht (30) eine dritte Schicht (45) aus dehnungsarmen Material, insbesondere aus einer Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), ausgebildet wird.

13. Verfahren nach Anspruch 12,
**dadurch gekennzeichnet, dass**
die erste Schicht (20), die zweite Schicht (30) und die dritte Schicht (45) bei einer Verbindungstemperatur von 150 °C - 300 °C, inbesondere durch ein Niedertemperatursinterverfahren, miteinander verbunden werden.

14. Elektronikmodul (80) mit mindestens einem Elektronikbauteil (70) und mit mindestens einer Wärmespreizplatte (10) nach einem der Ansprüche 1 bis 7 oder mit mindestens einer Wärmespreizplatte (10), hergestellt nach einem Verfahren nach einem der Ansprüche 8 bis 13,
**dadurch gekennzeichnet, dass**
mindestens ein Elektronikbauteil (70) mittelbar oder unmittelbar mit einer Seite (21) der ersten Schicht (20), die von der zweiten Schicht (30) abgewandt ausgebildet ist, verbunden ist.

15. Elektronikmodul (80) nach Anspruch 14,
**dadurch gekennzeichnet, dass**
die zweite Schicht (30) der Wärmespreizplatte (10) als ein, einem Kühlmedium, insbesondere Luft und/oder Wasser und/oder Glykol und/oder Öl, ausgesetztes Bauteil ausgebildet ist.

16. Elektronikmodul (80) nach Anspruch 15,
**dadurch gekennzeichnet, dass**
die mindestens eine Kühlfinne (50) in einem Winkel von 10° - 90°, insbesondere senkrecht oder parallel, zur Strömungsrichtung (S) des Kühlmediums ausgebildet ist.
